# EUROPÄISCHE PATENTANMELDUNG

(11) **EP 1 732 123 A2**
(43) Veröffentlichungstag der Anmeldung: **13.12.2006**
(21) Anmeldenummer: 06011596.1
(22) Anmeldetag: 06.06.2006
(51) Int. Cl.: H01L 21/768, H01L 21/283

(54) **Verfahren zum Herstellen eines Metall-Halbleiter-Kontakts bei Halbleiterbauelementen**

(30) Priorität: 06.06.2005 DE 102005026301
(71) Anmelder: ATMEL Germany GmbH, 74072 Heilbronn (DE)
(72) Erfinder: Dietz, Franz, 74257 Untereisesheim (DE); Dudek, Volker, 74336 Brackenheim (DE); Florian, Tobias, 70569 Stuttgart (DE); Graf, Michael, 71397 Leutenbach (DE)

(57) **Zusammenfassung**

2.1 Bei bekannten Verfahren besteht im Zuge von Metallabscheidungen ein relativ hohes Kontaminationsrisiko.
2.2 Bei dem neuen Verfahren wird der eigentliche Metall-Halbleiter oder Schottky-Kontakt erst nach dem Aufbringen eines schützenden Schichtsystems erzeugt, wodurch sich beliebige Metalle, insbesondere Platin, ohne Kontaminationsrisiko verwenden lassen.

## Beschreibung

Die Erfindung betrifft ein Verfahren zum Herstellen eines Metall-Halbleiter-Kontakts bei einem in einem Standardprozess erzeugten Halbleiterbauelement aus einem Halbleitermaterial, wie einem in einem Standard-CMOS-Prozess erzeugten Transistor, das zum Abschluss des Standardprozesses mit einem Schichtsystem aus einer Anordnung elektrisch isolierender und elektrisch leitfähiger Schichten (im Folgenden auch als BEOL-Schicht bezeichnet; BEOL: *back end of line*) versehen wird. Darüber hinaus betrifft die Erfindung ein Halbleiterbauelement, wie einen in einem Standard-CMOS-Prozess erzeugten Transistor, mit wenigstens einem nach einem erfindungsgemäßen Verfahren hergestellten Metall-Halbleiter-Kontakt und allgemein einen insbesondere lichtempfindlichen Metall-Halbleiter-Kontakt (Photodiode).

Halbleiterbauelemente mit einem Metall-Halbleiter-Kontakt, einem sog. Schottky-Kontakt, der aufgrund verschwindender Ladungsspeicherung im Durchlasszustand eine extrem schnell schaltende (Schottky-)Diode darstellt, was dem Fachmann bekannte schaltungstechnische Vorteile mit sich bringt, bzw. Verfahren zu deren Herstellung sind beispielsweise aus der DE 26 31 873 C2, der DE 29 21 971 C2, der EP 0 182 088 A1, der US 5,216,264, der US 6,656,823 B2, der US 6,784,035 B2 sowie aus einer Veröffentlichung von Soole und Schumacher aus dem Jahr 1990 (IEEE Trans. Electron. Devices 37, 2285) bekannt. Bestimmte Metall-Halbleiter-Kontakte, wie Wolfram (Wo)-Silizium, Titan (Ti)-Silizium oder Platin (Pt)-Silizium, besitzen darüber hinaus lichtempfindliche Eigenschaften und sind somit auch als Photodioden einsetzbar. Dabei ist regelmäßig ― sofern dies in den genannten Druckschriften explizit offenbart ist ― zum Erzeugen der Schottky-Kontakte das Abscheiden eines Metalls, je nach verwendetem Halbleitermaterial und dessen Dotierung, erforderlich. Dies ist nach dem Stand der Technik mit einer beträchtlichen Kontaminationsgefahr verbunden, da bestimmte Metalle (Me), insbesondere Pt, stark in das Halbleitermaterial, z.B. Silizium (Si), hinein diffundieren, was einen negativen Einfluss auf die Lebensdauer der Ladungsträger im Halbleiter hat. Dies kann Fehlfunktionen der betroffenen Bauteile zur Folge haben und zu Produktionsausschuss mit der damit verbundenen negativen Kostenfolge führen. Deshalb müssen in der Praxis die Herstellungsstätten für Halbleiterbauelemente streng von Me⁺-lonen frei gehalten werden.

In der Praxis wird zur Umgehung der vorstehend beschriebenen Problematik bei der Herstellung von Schottky-Dioden bzw. Photodioden und allgemein Halbleiterbauelementen mit Metall-Halbleiter-Kontakt(en) als Metall vorzugsweise Ti verwendet, das insbesondere mit Silizium-Halbleitermaterial gut bindet und kaum Diffusionseffekte zeigt. Allerdings bieten insbesondere Pt-Si-Kontakte bestimmte elektrische Vorteile: So besitzt Pt auf n-Si eine hohe Spannungsbarriere, sodass nur ein sehr geringer Dunkelstrom fließt, was für bestimmte Anwendungen einen großen Vorteil darstellt. Zudem bilden sich die notwendigerweise bei der Kontaktherstellung zwecks einer innigen Verbindung zu erzeugenden Me-Silizide im Falle von Ti erst bei Temperaturen T > 600°C, was beim Tempern zur Beschädigung bereits erzeugter Halbleiterstrukturen führen kann. Dagegen bilden sich Pt- oder Wo-Silizide bereits bei T < 300-400°C, weshalb eine mögliche Verwendung dieser Metalle weitere fertigungstechnische Vorteile mit sich brächte, in der Praxis im Zuge der bislang verwendeten Herstellungsverfahren jedoch nicht möglich ist.

Der Erfindung liegt die Aufgabe zugrunde, ein Verfahren der eingangs genannten Art so weiter zu entwickeln, dass es die Kontaminationsgefahr aufgrund von ungewollten (Fremd-)Metallabscheidungen minimiert, sodass die oben genannten nachteiligen Folgen möglichst vermeiden lassen und darüber hinaus beliebige Metalle, auch solche mit ungünstigem Diffusionsverhalten im Halbleitermaterial, zur Bildung der Kontakte verwendet werden können. Weiterhin besteht die Aufgabe der Erfindung darin, ein Verfahren anzugeben, mit dem sich im wesentlichen ohne Kontaminationsgefahr beliebige Fremdmetalle mit Standard-Halbleiterbauelementen verbinden lassen. Die Aufgabe erstreckt sich auch auf die Schaffung entsprechender Halbleiterbauelemente, insbesondere lichtempfindlicher Metall-Halbleiter-Kontakte (Photodioden).

Diese Aufgabe wird erfindungsgemäß gelöst durch ein Verfahren zum Herstellen eines Metall-Halbleiter-Kontakts bei einem in einem Standardprozess erzeugten Halbleiterbauelement aus einem Halbleitermaterial, wie einem in einem Standard-CMOS-Prozess erzeugten Transistor, das zum Abschluss des Standardprozesses mit einem Schichtsystem (BEOL-Schicht) aus einer Anordnung elektrisch isolierender und elektrisch leitfähiger Schichten versehen wird, wobei zunächst das Schichtsystem auf das Standard-Bauelement aufgebracht wird, anschließend zumindest ein Fenster in einem elektrisch isolierenden Bereich des Schichtsystems geöffnet wird und dann ein Metall zumindest im Bereich des Fensters aufgebracht wird, sodass zumindest das Halbleitermaterial im Bereich des Fenster stellenweise von dem Metall kontaktiert wird.

Der Kerngedanke der Erfindung besteht demnach darin, dass der eigentliche Metall-Halbleiter- oder Schottky-Kontakt erst am Ende des Standard-Prozesses nach dem Aufbringen des o.g. Anschluss-/Passivierungs-Schichtsystems (BEOL-Schicht) erzeugt wird, wodurch die oben aufgeführten Probleme vermieden werden. Ohne Kontaminationsrisiko lassen sich so beliebige Metalle, insbesondere Platin in Verbindung mit Silizium-Halbleitermaterial, verwenden. Hierzu wird das Schichtsystem in wenigstens einem elektrisch isolierenden Fensterbereich wieder entfernt, um das darunter liegende Halbleitermaterial direkt mit dem aufzubringenden Metall zu kontaktieren, wobei eine solche Vorgehensweise nach dem Stand der Technik aufgrund der relativ großen Fenstertiefe (typischer Weise mehrere Mikrometer) auf deutliche Vorurteile gestoßen wäre. Erfindungsgemäß lässt sich jedoch auf diese Weise die Herstellung des Metall-Halbleiter-Kontakt ohne Kontaminationsrisiko kostengünstig unmittelbar, ggf. modular, in die Abläufe zur Fertigung des Standard-Bauelements integrieren.

Die oben genannte Aufgabe wird auch gelöst durch ein Verfahren zum Herstellen von Halbleiterbauelementen, das ein erfindungsgemäßes Verfahrensmodul beinhaltet. Dabei kann das Verfahrensmodul als Prozess-Modul in einer an den Standardprozess angeschlossenen Spezial-Fertigungslinie oder extern, d.h. in einer bezüglich des Standardprozesses externen Produktionsstätte ablaufen.

Die oben genannte Aufgabe wird weiterhin gelöst durch ein Halbleiterbauelement, wie einen in einem Standard-CMOS-Prozess erzeugten Transistor, mit wenigstens einem nach einem erfindungsgemäßen Verfahren hergestellten Metall-Halbleiter-Kontakt. Vorzugsweise handelt es sich bei dem Substrat des Halbleiterbauelements ― dem Halbleitermaterial ― um ein geeignet p- oder n-dotiertes Silizium-Substrat. Jedoch kommen auch andere Substrate, wie ein SOI-Substrat (SOI: *silicon on insulator*), in Betracht.

In Weiterbildung des erfindungsgemäßen Verfahrens ist vorgesehen, dass vor dem Aufbringen des Schichtsystems ein im wesentlichen im Bereich des Fensters befindlicher Kontaktbereich des Halbleiterbauelements mit einer Einwirkungs-Stoppschicht, wie einer Ätzstoppschicht, abgedeckt wird, sodass beim Öffnen des Fensters nicht auf unterhalb der Einwirkungs-Stoppschicht liegenden Bereiche des Halbleiterbauelements eingewirkt wird.

Anschließend erfolgt erfindungsgemäß das Öffnen des Fensters in dem Schichtsystem, beispielsweise im Ätzverfahren, in einem elektrisch isolierenden Bereich oberhalb der Ätzstoppschicht, das in der Folge als Diodenfenster für die Herstellung des Schottky-Kontakts dienen soll. Vorzugsweise wird danach die Ätzstoppschicht zumindest im Bereich des Fensters wieder entfernt.

Um den bzw. die eigentlichen Metall-Halbleiter-Kontakt(e) zu schaffen, zeichnet sich eine vorteilhafte Weiterbildung des erfindungsgemäßen Verfahrens dadurch aus, dass nun im Bereich des (Dioden-)Fensters Kontaktöffnungen für das Metall in Schichten des Halbleiterbauelements geschaffen werden, die bis zumindest auf das Halbleitermaterial reichen. Nach diesem Strukturieren der Fensteröffnung wird daraufhin das Metall auf die freiliegenden Oberflächen aufgebracht und kontaktiert auf diese Weise direkt zumindest das Halbleitermaterial, d.h. dessen Oberfläche bzw. diejenige des Halbleiterbauelements.

Dann erfolgt erfindungsgemäß nach erfolgtem Aufbringen des Metalls zwecks Schaffung einer innigen Verbindung des Metalls mit dem Kontaktmaterial ― z.B. n-Silizium ― eine Wärmebehandlung in Form einer Temperung, sodass an den Kontaktstellen von Metall und Halbleitermaterial Kontaktbereiche aus chemischen Verbindungen des Metalls mit dem Halbleitermaterial gebildet werden. Nach der vorliegend beschriebenen bevorzugten Ausgestaltung der Erfindung bilden sich so chemische Verbindungen in Form von Siliziden, vorzugsweise Pt-Si oder Wo-Si; anschließend wird vorteilhafter Weise das chemisch unveränderte Metall entfernt, sodass die silizidierten Kontaktstellen freiliegen.

Nach erfolgter Entfernung des Metalls wird dann im Zuge der vorliegenden Erfindung auf den Kontaktbereichen zur Verhinderung weiterer Diffusion ein elektrisch leitfähiges Barrierematerial, z.B. Titan, aufgebracht, sodass die Kontaktöffnungen im wesentlichen vollständig gefüllt sind. Anschließend kann zumindest in Bereichen oberhalb der Kontaktöffnungen und in Kontakt mit zumindest dem Barrierematerial ein Kontaktmaterial, wie ein Kontaktmetall, zur elektrischen Kontaktierung der geschaffenen Schottky-Dioden aufgebracht werden. Die so geschaffenen Kontakte werden anschließend in eine hier nicht näher zu spezifizierende mit der Schottky-Diode verbundene Schaltung geführt.

Am Ende des erfindungsgemäßen Verfahrens wird in äußerst bevorzugter Weiterentwicklung zum Schutz der darunter liegenden Schichten auf alle freiliegenden Oberflächen des Halbleiterbauelements eine Passivierungsschicht aufgebracht, z.B. eine Oxidschicht.

Somit ergeben sich durch die vorliegende Erfindung beste Eigenschaften der Fremdmetall-Schichten, insbesondere des vorstehend detailliert beschriebenen Schottky-Kontakts, da auf dessen Erzeugung kein weiteres Temperaturprozesssing oder keine weitere BEOL-Strukturierung mehr folgt, die sich aufgrund ihrer aggressiven Einwirkung nachteilig auf die Eigenschaften der Schichten des Halbleiterbauelements auswirken könnte.

Weitere Vorteile und Eigenschaften der Erfindung ergeben sich aus den Unteransprüchen sowie der nachfolgenden Beschreibung eines Ausführungsbeispiels anhand der Zeichnung. Es zeigen:
- Fig. 1: bis
- Fig. 14: zeitlich aufeinander folgende erfindungsgemäße Verfahrensschritte zum Herstellen eines Schottky-Kontakts.

Im Folgenden wird die erfindungsgemäße Herstellung eines Schottky-Kontakts im Rahmen eines bevorzugten Ausführungsbeispiels anhand von Schnittansichten eines betreffenden Halbleiterbauelements beschrieben. Bei dem Halbleiterbauelement kann es sich um einen Standard-CMOS-Transistor handeln. Allerdings ist die Erfindung nicht hierauf beschränkt, sondern umfasst weiterhin neben bipolaren Transistoren auch alle weiteren Halbleiterbauelemente, bei denen Metall-Halbleiter-Kontakte zum Einsatz kommen.

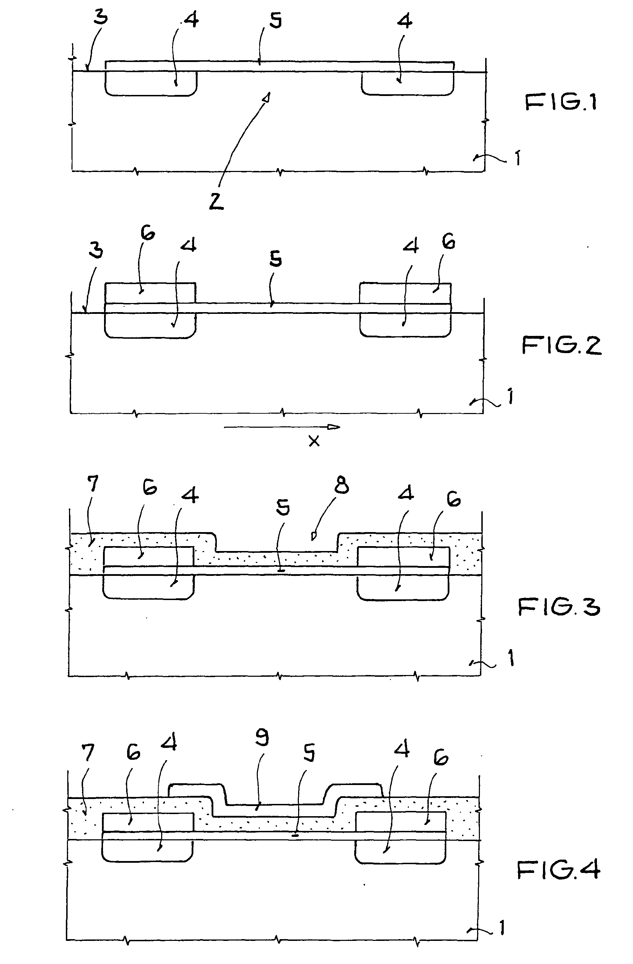

Gemäß der Fig. 1 wird zunächst in an sich bekannter Weise bei einem standardmäßig hergestellten Halbleiterbauelement 1, hier insbesondere einem CMOS-Transistor aus geeignet dotiertem Silizium, z.B. n-Silizium, im Standard-Herstellungsprozess ein Bereich 2 (Kontaktbereich) auf dem Halbleiterbauelement 1 und an dessen Oberfläche 3 mittels einer elektrisch isolierenden Feldoxid-Schicht 4 geometrisch definiert und mittels einer weiteren elektrisch isolierenden Schicht 5 abgedeckt. Bei der weiteren Schicht 5 handelt es sich insbesondere um eine Gateoxid-Schicht, beispielsweise aus thermisch aufgewachsenem Siliziumoxid (SiO₂), die durch einen Isolator mit hoher Dielektrizitätskonstante ersetzbar ist. Die Feldoxid-Schicht 4 kann dabei vorteilhafter Weise ringförmig ausgebildet sein und begrenzt so den Bereich 2 allseitig. Das Aufbringen (und Abheben bzw. Strukturieren) dieser und der weiteren erfindungsgemäß anzuordnenden Schichten erfolgt mittels standardmäßiger Techniken, wie CVD, Nassoxidation, photolithographischer Masken-Strukturierung, Ätzen oder dgl.

Anschließend wird gemäß der Fig. 2 eine Verbindung zwischen dem Erzeugnis des Standardprozesses (s.o.) und der zu schaffenden Schottky-Diode in Form einer Verbindungsschicht 6 aus Polysilizium auf das Gateoxid 5 stellenweise aufgebracht. "Stellenweise" bedeutet hierbei, dass das Polysilizium nicht flächendeckend auf der o.g. Oxidschicht aufgebracht wird. Die Verbindungsschicht 6 fluchtet nach dem gezeigten Ausführungsbeispiel dekkend mit der Feldoxid-Schicht 4, wobei die seitlichen Abmessungen der genannten Schichten 4, 6 in Richtung des Pfeils X identisch sind.

Gemäß dem in der Fig. 3 dargestellten nächsten Verfahrensschritt wird daraufhin die Diode, d.h. die vorstehend beschriebene Anordnung aus Feldoxid-Schicht 4, Gateoxid-Schicht 5 und Polysilizium-Verbindungsschicht 6 mit einem isolierenden Material 7, wie einem Oxid oder einem geeigneten dielektrischen Isolatormaterial, z.B. BPSG, abgedeckt. Nach dem gezeigten Ausführungsbeispiel ergibt sich so eine Vertiefung 8 in dem isolierenden Material 7 oberhalb des Bereich 2 (vgl. Fig. 1).

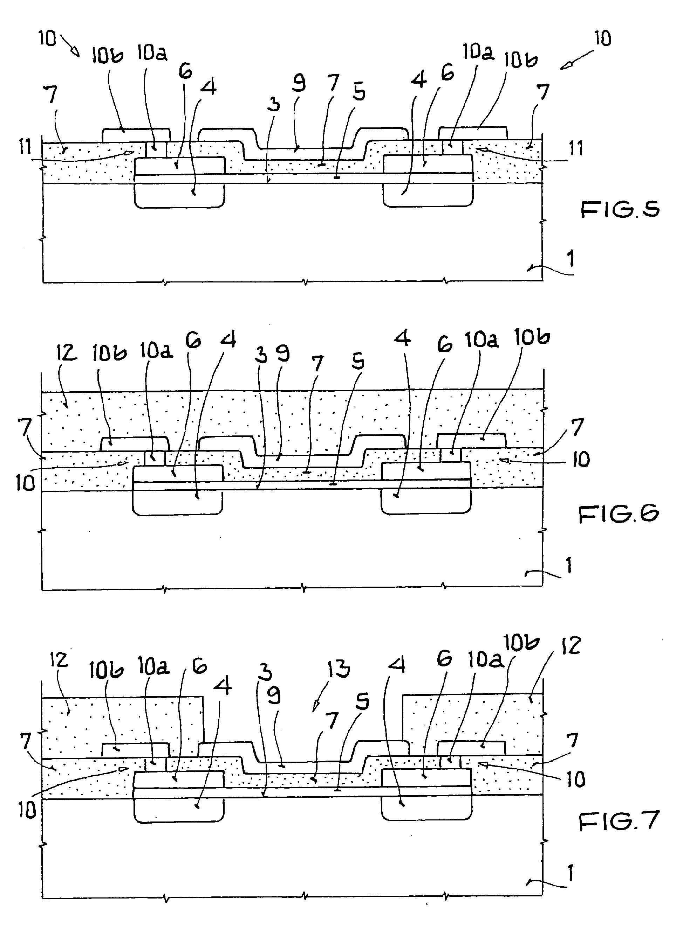

Anschließend wird nach der Darstellung in Fig. 4 eine Ätzstoppschicht 9 aus Polysilizium im Bereich der Vertiefung 8 und darüber hinaus (vgl. Fig. 3) auf das isolierende Material 7 aufgebracht. Weiterhin zeigt die folgende Fig. 5 das Anbringen eines Anschlusses 10 auf der CMOS-Seite, d.h. auf der dem Bereich 2 (Fig. 1) abgewandten Seite der bislang geschaffenen Anordnung: Dazu wird zunächst eine Öffnung 11 in dem isolierenden Material 7 erzeugt und mit einem elektrisch leitfähigen Material 10a, wie Aluminium (AI), Si oder Kupfer (Cu), angefüllt, sodass eine anschließend auf das isolierende Material 7 seitlich der Ätzstoppschicht 9 aufgebrachte Anschlussschicht 10b die Verbindungsschicht 6 leitend kontaktiert.

Gemäß der Fig. 6 wird danach ein Schichtsystem 12 aus einer Anordnung elektrisch leitfähiger Anschluss-Schichten und elektrisch isolierender Passivierungs- bzw. Isolations-Schichten aus Oxid(en) und Metallen (zu Anschlusszwecken) auf die gemäß der Fig. 5 freiliegenden Strukturen 7, 9, 10b des Halbleiterbauelements 1 aufgebracht. Das Schichtsystem 12, dessen genaue innere Struktur hier nicht dargestellt ist, wird im Rahmen der vorliegenden Erfindung auch als BEOL-Schicht bezeichnet.

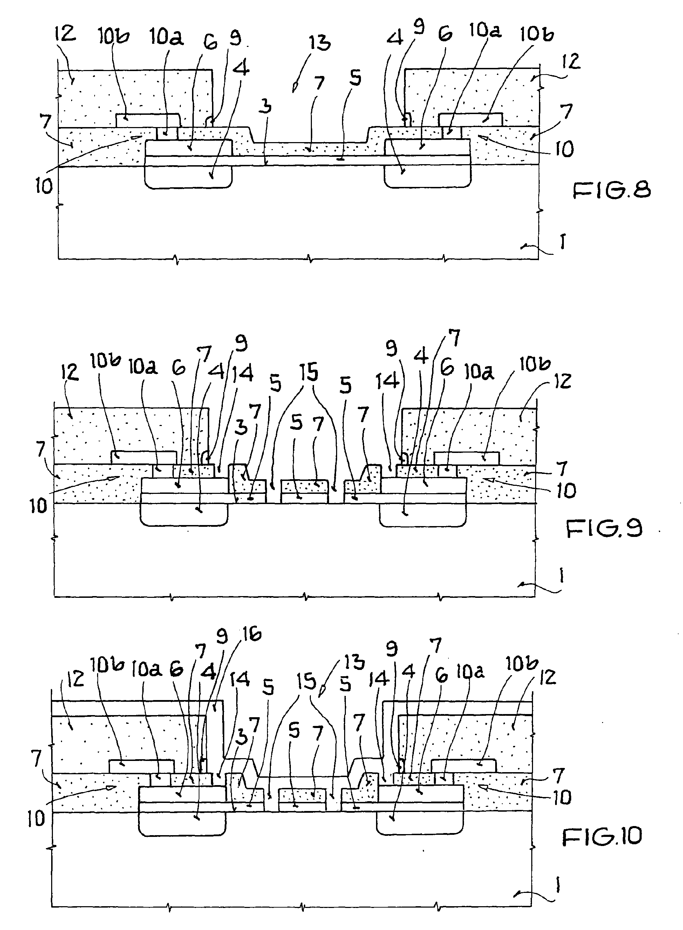

In dieser BEOL-Schicht 12 wird anschließend ― Fig. 7 ― oberhalb des elektrisch isolierenden Bereichs 2 (Fig. 1) durch Materialabhebung ein Fenster 13 geöffnet wird, sodass die Ätzstoppschicht 9 in diesem Bereich frei liegt. Die Ätzstoppschicht 9 wird dann in einem nachfolgenden Verfahrensschritt gemäß der Fig. 8 teilweise entfernt, sodass nunmehr im Bereich des Fensters 13 das isolierende Material 7 exponiert ist.

Mittels an sich bekannter Standardverfahren wird anschließend die Fensteröffnung strukturiert, indem einerseits rillenförmige Öffnungen 14 in dem isolierenden Material 7 oberhalb der Verbindungsschicht 6 und andererseits Öffnungen 15 in dem isolierenden Material 7 und in der Gateoxid-Schicht 6 oberhalb des Bereichs 2 (Fig. 1) geschaffen werden, wobei die Öffnungen 14, 15, die erfindungsgemäß als Kontaktöffnungen fungieren, jeweils bis auf die Verbindungsschicht 6 bzw. bis auf die Oberfläche 3 des Halbleitermaterials des Halbleiterbauelements 1 hinab reichen und sich weiterhin in die Zeichenebene hinein erstrecken können. Dies ist in der Fig. 9 im Schnitt dargestellt.

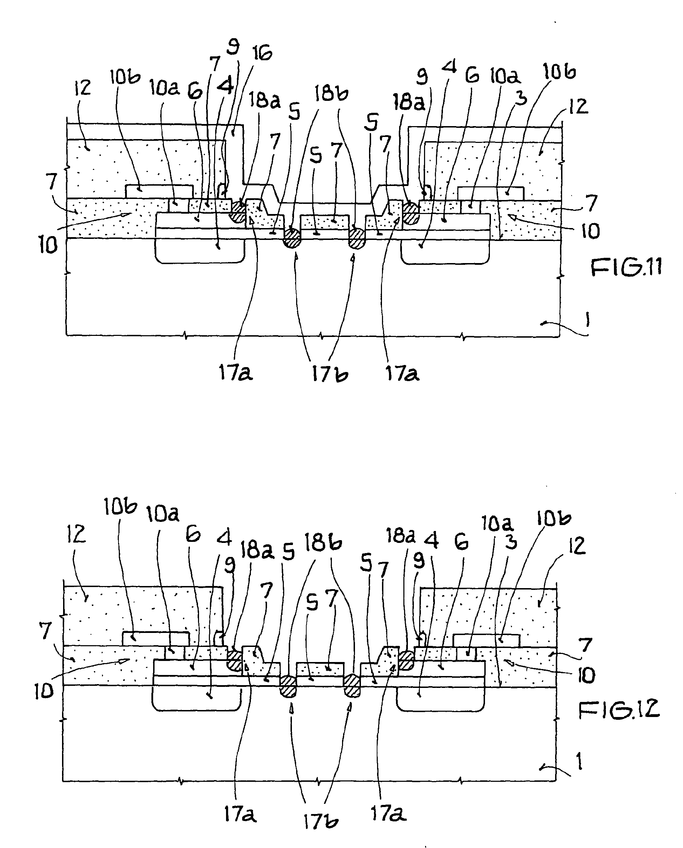

Gemäß der Fig. 10 wird dann ein geeignetes Metall 16, nach dem vorliegenden Ausführungsbeispiel, vorzugsweise Platin zwecks Schaffung eines lichtempfindlichen Kontaktes mit geringem Dunkelstrom, auf das Schichtsystem 12 sowie auf alle im Bereich des Fensters 13 freiliegenden Oberflächen abgeschieden, insbesondere auf die Verbindungsschicht 6 bzw. die Halbleiter-Oberfläche 3 im Bereich der Öffnungen 14, 15. Danach wird die so geschaffene Struktur einer Wärmebehandlung (Temperung) unterzogen, wodurch sich an den Kontaktstellen 17a, 17b von Metall 16 und Polysilizium 6 bzw. von Metall 16 und dem Halbleitermaterial des Bauelements 1 ein entsprechendes Silizid 18a, 18b, vorzugsweise Pt-Si, bildet. Dies ist in der Fig. 11 dargestellt. Die Temperung erfolgt vorzugsweise bei ca. 300 bis 500°C und liegt damit betreffend die Temperatur und eine eventuell vorhandene Schadeinwirkung deutlich unterhalb derjenigen für herkömmlich verwendetes Titan (T ≈600°C).

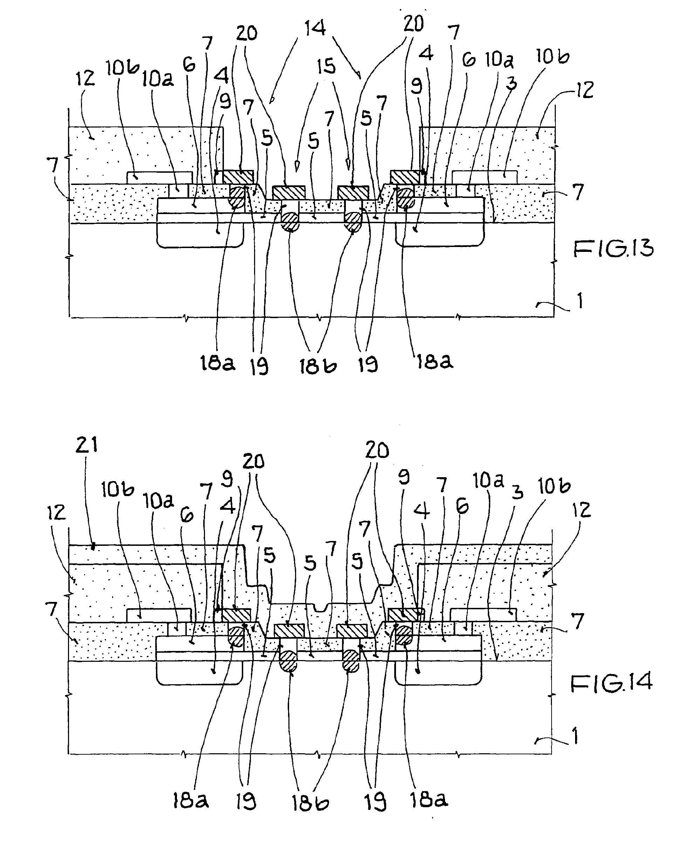

Anschließend wird gemäß der Fig. 12 das nicht silizidierte Metall 16 entfernt, sodass insbesondere die Silizid-Bereiche 18a, 18b frei liegen. Auf diese wird dann, wie in der Fig. 13 gezeigt ist, ein geeignetes Barrierematerial 19 aufgebracht, beispielsweise Titan, sodass die Kontaktöffnungen 14, 15 im wesentlichen vollständig mit dem Barrierematerial 19 gefüllt sind. Das Barrierematerial bewirkt aufgrund seiner speziellen Eigenschaften, dass keine unkontrollierte Diffusion von Metallionen stattfindet. Auf dem Barrierematerial 19 wird anschließend ein Kontaktmetall 20, vorzugsweise Al oder Cu, abgeschieden. Anstelle eines Metalls ist jedoch auch ein Abscheiden von Si möglich.

Die abschließende Fig. 14 zeigt das Aufbringen einer Passivierung 21 aus Oxid oder einem anderen geeigneten dielektrischen Isolatormaterial zum Passivieren und Schützen des so geschaffenen erfindungsgemäßen Halbleiterbauelements mit Metall-Halbleiter-Kontakt (Schottky-Kontakt). Die Schicht 21 kann vorteilhafter Weise als ARC-Schicht (ARC: anti-reflective coating), z.B. als λ/4-Schicht, ausgebildet sein, wenn der Brechungsindex n und die Schichtdicke bekannt sind, sodass ein Transmissionsmaximum für Lichteinstrahlung auf das lichtempfindliche Element erzielbar ist. Das Licht kann erfindungsgemäß dabei direkt von oben auf die Diodenstruktur eingestrahlt werden. Alternativ oder zusätzlich können auch laterale Lichtleitungen im Halbleitermaterial zum Ort des Metall-Halbleiter-Kontakts vorgesehen sein (hier nicht gezeigt), die beispielsweise die Transparenz von Si in bestimmten Spektralbereichen ausnutzen.

Weiterhin können auch unterhalb der Silizid-Bereiche noch Barrierewannen (ebenfalls nicht dargestellt) im Halbleitermaterial vorgesehen sein, um eine Diffusion von Metall in das Halbleiterbauelement zu unterbinden.

Mittels des vorstehend beschriebenen Verfahrens können gezielt lichtempfindliche Schottky-Kontakte (Photodioden) bzw. Halbleiterbauelemente, wie in einem Standard-CMOS-Prozess erzeugte Transistoren, mit wenigstens einem Metall-Halbleiter-Kontakt unter Verwendung beliebiger Metalle, jedoch vorzugsweise Platin bzw. Metallen mit ähnliche Eigenschaften, realisiert werden, ohne dass es aufgrund von Metallabscheidungen zu einem Kontaminationsrisiko für die Herstellungsvorrichtung bzw. das herzustellende Bauelement käme, was durch die detailliert dargelegte Prozesstrennung (zunächst Herstellung des Halbleiterbauelements, dann Erzeugung des Metall-Halbleiter-Kontakts wie beschrieben) erreicht wird.

### Bezuaszeichenliste

- 1: Halbleiterbauelement, CMOS-Transistor
- 2: (Dioden-)Bereich
- 3: Oberfläche (von 1)
- 4: elektrisch isolierende Schicht, Feldoxid-Schicht
- 5: elektrisch isolierende Schicht, Gateoxid-Schicht
- 6: Verbindungsschicht, Polysilizium
- 7: elektrisch isolierendes Material
- 8: Vertiefung
- 9: Ätzstoppschicht
- 10: Anschluss
- 10a: elektrisch leitfähiges Material
- 10b: Anschlussschicht
- 11: Öffnung
- 12: Schichtsystem (BEOL-Schicht)
- 13: Fenster
- 14: Öffnung
- 15: Öffnung
- 16: Metall (Platin)
- 17a: Kontaktstelle

- 17b: Kontaktstelle
- 18a: Silizid-Bereich
- 18b: Silizid-Bereich
- 19: Barrierematerial
- 20: Kontaktmetall
- 21: Passivierung
- X: seitliche Richtung

## Patentansprüche

1. Verfahren zum Herstellen eines Metall-Halbleiter-Kontakts bei einem in einem Standardprozess erzeugten Halbleiterbauelement aus einem Halbleitermaterial, wie einem in einem Standard-CMOS-Prozess erzeugten Transistor, das zum Abschluss des Standardprozesses mit einem Schichtsystem aus einer Anordnung elektrisch isolierender und elektrisch leitfähiger Schichten versehen wird, wobei
• zunächst das Schichtsystem auf das Standard-Bauelement aufgebracht wird,
• anschließend zumindest ein Fenster in einem elektrisch isolierenden Bereich des Schichtsystems geöffnet wird und
• dann ein Metall zumindest im Bereich des Fensters aufgebracht wird, sodass zumindest das Halbleitermaterial im Bereich des Fenster stellenweise von dem Metall kontaktiert wird.

2. Verfahren nach Anspruch 1, **dadurch gekennzeichnet, dass** vor dem Aufbringen des Schichtsystems ein im wesentlichen im Bereich des Fensters befindlicher Kontaktbereich des Halbleiterbauelements mit einer Einwirkungs-Stoppschicht, wie einer Ätzstoppschicht, abgedeckt wird, sodass beim Öffnen des Fensters nicht auf unterhalb der Einwirkungs-Stoppschicht liegenden Bereiche des Halbleiterbauelements eingewirkt wird.

3. Verfahren nach Anspruch 2, **dadurch gekennzeichnet, dass** das Fenster in dem Schichtsystem in einem Bereich oberhalb der Ätzstoppschicht geöffnet wird.

4. Verfahren nach Anspruch 2 oder 3, **dadurch gekennzeichnet, dass** nach dem Öffnen des Fensters die Ätzstoppschicht zumindest im Bereich des Fensters entfernt wird.

5. Verfahren nach Anspruch 4, **dadurch gekennzeichnet, dass** im Bereich des Fensters Kontaktöffnungen für das Metall in Schichten des Halbleiterbauelements geschaffen werden, die bis zumindest auf das Halbleitermaterial reichen.

6. Verfahren nach Anspruch 5, **dadurch gekennzeichnet, dass** das Metall nach erfolgtem Schaffen der Kontaktöffnungen aufgebracht wird.

7. Verfahren nach einem der vorangehenden Ansprüche, **dadurch gekennzeichnet, dass** als Metall Platin oder Wolfram verwendet wird.

8. Verfahren nach einem der vorangehenden Ansprüche, **dadurch gekennzeichnet, dass** als Halbleitermaterial Silizium, insbesondere n-dotiertes Silizium, verwendet wird.

9. Verfahren nach einem der vorangehenden Ansprüche, **dadurch gekennzeichnet, dass** nach erfolgtem Aufbringen des Metalls eine Wärmebehandlung stattfindet, sodass an den Kontaktstellen von Metall und Halbleitermaterial Kontaktbereiche aus chemischen Verbindungen, insbesondere Siliziden, des Metalls mit dem Halbleitermaterial gebildet werden.

10. Verfahren nach Anspruch 9, **dadurch gekennzeichnet, dass** anschließend das chemisch unveränderte Metall entfernt wird.

11. Verfahren nach Anspruch 10, **dadurch gekennzeichnet, dass** nach erfolgter Entfernung des Metalls auf die Kontaktbereiche ein elektrisch leitfähiges Barrierematerial, insbesondere Titan, aufgebracht wird, sodass die Kontaktöffnungen im wesentlichen vollständig gefüllt sind.

12. Verfahren nach Anspruch 11, **dadurch gekennzeichnet, dass** zumindest in Bereichen oberhalb der Kontaktöffnungen und in Kontakt mit zumindest dem Barrierematerial ein Kontaktmaterial, wie ein Kontaktmetall, aufgebracht wird.

13. Verfahren nach Anspruch 12, **dadurch gekennzeichnet, dass** anschließend auf alle freiliegenden Oberflächen des Halbleiterbauelements eine Passivierungsschicht aufgebracht wird.

14. Verfahren zum Herstellen von Halbleiterbauelementen, **gekennzeichnet durch** ein Verfahrensmodul nach einem der vorangehenden Ansprüche.

15. Halbleiterbauelement, wie ein in einem Standard-CMOS-Prozess erzeugten Transistor, mit wenigstens einem nach einem Verfahren gemäß einem der vorangehenden Ansprüche hergestellten Metall-Halbleiter-Kontakt.

16. Lichtempfindlicher Metall-Halbleiter-Kontakt, hergestellt nach einem Verfahren gemäß einem der vorangehenden Ansprüche.
